# EUROPEAN PATENT APPLICATION

(11) **EP 2 960 949 A1**
(43) Date of publication of application: **30.12.2015**
(21) Application number: 15172716.1
(22) Date of filing: 18.06.2015
(51) Int. Cl.: H01L 31/048, C03C 17/34, H02S 30/10

(54) **METHOD OF MANUFACTURING SOLAR CELL MODULE, METHOD OF MANUFACTURING TRANSLUCENT OR TRANSPARENT SUBSTRATE, AND SOLAR CELL MODULE**

(30) Priority: 27.06.2014 JP 2014133085
(71) Applicant: Panasonic Intellectual Property Management Co., Ltd., Osaka-shi, Osaka 540-6207 (JP)
(72) Inventor: Yano, Hirofumi, Daito-shi, Osaka 574-8534 (JP); Ueno, Hiroyuki, Daito-shi, Osaka 574-8534 (JP); Naito, Ryoji, Daito-shi, Osaka 574-8534 (JP); Yagiura, Toshio, Daito-shi, Osaka 574-8534 (JP)
(74) Representative: Glawe, Delfs, Moll

(57) **Abstract**

An aspect of the invention provides a method of manufacturing a solar cell module that comprises a step of obtaining a solar cell module that includes a translucent or transparent substrate including a substrate provided with translucency or transparency, and an antireflection film formed on a surface of the substrate provided with translucency or transparency, and a siloxane coat step of forming a siloxane layer on a surface of the antireflection film.

## Description

### BACKGROUND OF THE INVENTION

### 1. Field of the Invention

The invention relates to a method of manufacturing a solar cell module, a method of manufacturing a translucent or transparent substrate, and a solar cell module.

### 2. Description of the Related Art

Conventionally, solar cell modules have been developed as photoelectric conversion devices that convert light energy into electric energy. Solar cell modules can convert inexhaustible sunlight directly into electricity. In addition, solar cell modules impose less environmental load and are cleaner than power generation using fossil fuels. Hence, solar cell modules are expected to serve as a new energy source.

A solar cell module of this type has, for example, a structure in which solar cells, which are photoelectric conversion bodies, are sealed with a filler material between a glass substrate and a back cover. To capture more light, some solar cell modules further have an antireflection film (AR coat: Anti Reflection Coat) formed on a surface of a glass substrate on the light-receiving side.

For example, Japanese Patent Application Publication No. 2012-124386 discloses a thin film solar cell module in which a multilayer antireflection film is further formed on a surface of an antireflection layer formed on a glass substrate to obtain an excellent light confinement effect.

### SUMMARY OF THE INVENTION

However, a solar cell module in which an antireflection film is formed has such a problem that when dirt such as a fat component adheres to the antireflection film, it is difficult to remove the dirt. In this case, once attached to the antireflection film, dirt is difficult to remove even by cleaning the surface of the antireflection film for removing the attached dirt. If a fat component or the like adheres to the antireflection film, and the antireflection film is left dirty as described above, performances of the solar cell module deteriorate.

The invention has been made to solve the problem, and an object of the invention is to provide a method of manufacturing a solar cell module, a method of manufacturing a translucent or transparent substrate, and a solar cell module which make it possible to easily remove dirt such as a fat component attached to an antireflection film.

To solve the above-described problem, an aspect of a method of manufacturing a solar cell module according to an embodiment comprises a step of obtaining a solar cell module that including a translucent or transparent substrate including a substrate provided with translucency or transparency and an antireflection film formed on a surface of the substrate provided with translucency or transparency, and a siloxane coat step of forming a siloxane layer on a surface of the antireflection film.

Meanwhile, an aspect of a method of manufacturing a solar cell module comprises obtaining a solar cell module that includes translucent or transparent substrate including a substrate provided with translucency or transparency and an antireflection film formed on a surface of the substrate, forming a siloxane layer on a surface of the antireflection film.

Meanwhile, an aspect of a solar cell module according to an embodiment comprises a translucent or transparent substrate on a light-receiving side, wherein the translucent or transparent substrate includes a substrate provided with translucency or transparency, anantireflectionfilmformedon a surface of the substrate provided with translucency or transparency, and a siloxane layer formed on a surface of the antireflection film.

Moreover, an aspect of a translucent or transparent substrate on a light-receiving side of a solar cell module according to the invention comprises a substrate provided with translucency or transparency, anantireflectionfilmformedon a surface of the substrate provided with translucency or transparency, and a siloxane layer formed on a surface of the antireflection film.

### BRIEF DESCRIPTION OF THE DRAWINGS

Fig. 1 is a partial cross-sectional view of a translucent or transparent substrate according to an embodiment of the invention.
Fig. 2 is a diagram illustrating an example of a siloxane compound.
Figs. 3A and 3B are diagrams for describing a method of manufacturing a translucent or transparent substrate according to an embodiment of the invention.
Figs. 4A to 4D are diagrams for describing processes in an experiment conducted to check whether an antireflection film is coated with a siloxane layer on a translucent or transparent substrate according to the embodiment of the invention.
Fig. 5A is a graph illustrating a measurement result of a surface layer (exposed layer) in a region where a light shield member is placed on a translucent or transparent substrate according to the embodiment of the invention by time-of-flight secondary ion mass spectrometry (TOF-SIMS).
Fig. 5B is a graph illustrating the TOF-SIMS measurement result of a surface layer (exposed layer) in a region where no light shield member is placed on the translucent or transparent substrate according to the embodiment of the invention.
Figs. 6A to 6D are diagrams schematically illustrating a surface reaction in the region where the light shield member is placed in Figs. 4A to 4D.
Figs. 7A and 7B are diagrams for describing operations and effects of the translucent or transparent substrate according to the embodiment of the invention.
Fig. 8A is a diagram for describing a method of evaluating dirt attached to a translucent or transparent substrate according to the embodiment of the invention.
Fig. 8B is a graph illustrating an example of a reflectance distribution of the translucent or transparent substrate used for the evaluation illustrated in Fig. 8A.
Fig. 9 is a plan view of a solar cell module according to an embodiment of the invention.
Fig. 10 is an enlarged cross-sectional view of a part of the solar cell module taken along the line A-A' of Fig. 9.
Figs. 11A to 11H are diagrams for describing a method of manufacturing a solar cell module according to an embodiment of the invention.
Fig. 12 is a diagram for describing how siloxane layers are formed on substrates before actual mounting on a module.
Fig. 13 is a diagram for describing how siloxane layers are formed on substrates after actual mounting on a module.

### DESCRIPTION OF THE EMBODIMENTS

Hereinafter, embodiments of the invention are described with reference to the drawings. Each of the embodiments described below illustrates a specific preferred example of the invention. Accordingly, numeric values, shapes, materials, constituents, arranged positions of constituents, connecting modes of constituents, and the like illustrated in the embodiments below are mere examples, and are not intended to limited the invention. Therefore, in the embodiments below, constituents not described in any one of independent claims illustrating the broadest concept of the invention are optional constituents.

Note that the drawings are schematic, and are not necessarily depicted precisely. In addition, among the drawings, substantially the same components are denoted by the same reference numerals, and overlapping descriptions are omitted or simplified.

### (Embodiments)

### [Translucent or Transparent Substrate]

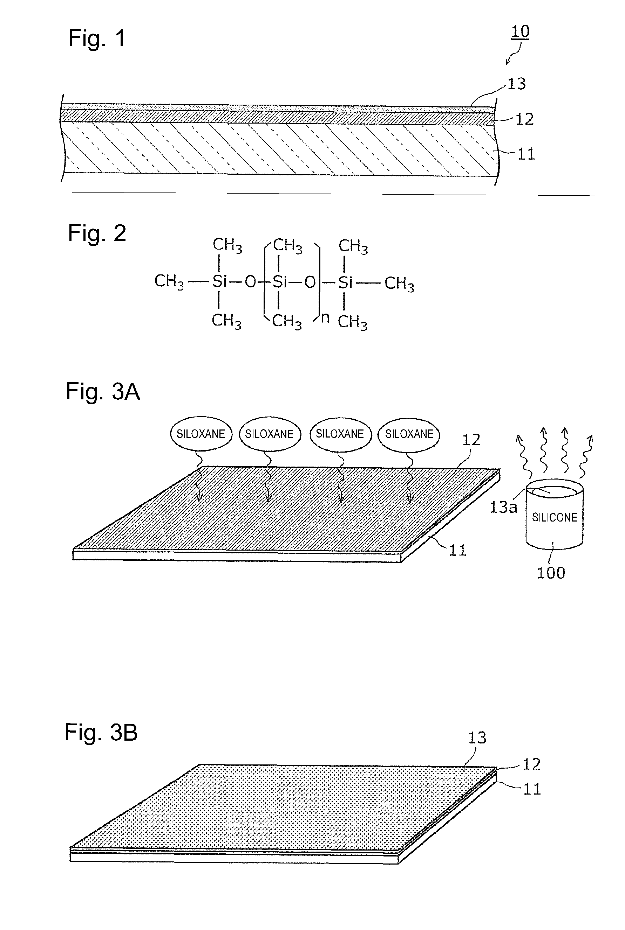

First, a configuration of translucent or transparent substrate 10 (hereinafter referred to as transparent substrate 10) according to an embodiment of the invention is described using Fig. 1. Fig. 1 is a partial cross-sectional view of the translucent or transparent substrate according to the embodiment of the invention.

As illustrated in Fig. 1, transparent substrate 10 includes substrate 11 provided with translucency or transparency, antireflection film 12 formed on a surface of substrate 11, and siloxane layer 13 formed on a surface of antireflection film 12.

Transparent substrate 10 is a low-reflection substrate in which antireflection film 12 is formed on the surface of substrate 11, and is used as, for example, a surface protective member of a solar cell module. Hereinafter, constituent members of transparent substrate 10 are described in detail.

Substrate 11 is, for example, a glass substrate (transparent glass substrate) made of a transparent glass material. Note that substrate 11 is not limited to a glass substrate, but may be a resin substrate made of a translucent or transparent resin material such as a transparent resin material, or the like.

Antireflection film 12 is formed to facilitate the capture of incoming light (for example, visible light such as sunlight) into substrate 11. By forming antireflection film 12 on substrate 11, it is possible to reduce reflection of incident light on a light-receiving surface (exposed surface) of transparent substrate 10.

In antireflection film 12, a low-reflection structure may be achieved by devising a material itself, for example, by using a low-reflection material. Alternatively, the low-reflection structure may be achieved by devising a surface shape or an inner shape, for example, by performing a process of forming a rugged surface on a translucent or transparent material, or forming voids in the translucent or transparent material. In this embodiment, the surface of antireflection film 12 has a rugged structure. In addition, the surface of antireflection film 12 is hydrophilic in this embodiment. An SiO₂-based material, a TiO₂-based material, a hydrophilic acrylic monomer, or the like can be used as a material of antireflection film 12. Note that antireflection film 12 has a film thickness of, for example, about 100 nm.

Antireflection film 12 configured as described above is, for example, formed to cover substantially the entire surface of substrate 11. Note that antireflection film 12 may have a single-layer structure or a multilayer structure.

Siloxane layer 13 is a layer (siloxane coat layer) formed by coating the surface of antireflection film 12 with siloxane. The siloxane is a compound having a skeleton of silicon atoms (Si) and oxygen atoms (O), and has Si-O-Si linkage (siloxane linkage). For example, the siloxane is a compound illustrated in Fig. 2. Siloxane layer 13 has a film thickness of 5 nm or less, namely, about a few nanometers.

Since siloxane is hydrophobic, the surface of siloxane layer 13 is hydrophobic. In this embodiment, siloxane layer 13 is formed on substantially the entire surface of antireflection film 12. In other words, substantially the entire surface of antireflection film 12 is coated with the siloxane. Accordingly, the light-receiving surface (exposed surface) of transparent substrate 10 is a hydrophobic surface. Note that cases where siloxane layer 13 is formed on substantially the entire surface of antireflection film 12 include a case where siloxane layer 13 is formed on the entire surface of antireflection film 12 without any space, as well as a case where siloxane layer 13 is formed on the entire surface of antireflection film 12, although a little area where siloxane layer 13 is not formed is present.

Moreover, although siloxane layer 13 is described to be formed on substantially the entire surface of antireflection film 12 in this embodiment, siloxane layer 13 may be formed on part of the surface of antireflection film 12, instead of substantially the entire surface of antireflection film 12. For example, siloxane layer 13 may be formed in an area not more than a half of the surface of antireflection film 12. Moreover, if an area which requires siloxane layer 13 is small, siloxane layer 13 may be formed in the small area on the surface of antireflection film 12.

Next, a method of manufacturing transparent substrate 10 according to this embodiment is described using Figs. 3A and 3B. Fig. 3A and 3B are diagrams for describing the method of manufacturing a translucent or transparent substrate according to this embodiment.

First, as illustrated in Fig. 3A, substrate 11 on a surface of which antireflection film 12 is formed is prepared (substrate preparation process).

Subsequently, a surface of antireflection film 12 is coated with siloxane (siloxane coat process). Thus, siloxane layer 13 is formed on the surface of antireflection film 12, as illustrated in Fig. 3B.

Inthiscase, for example, container 100 containing silicone 13a is placed as illustrated in Fig. 3A. Thus, the surface of antireflection film 12 can be coated with siloxane by using siloxane (siloxane gas) spontaneously vaporizing (eliminated) from silicone 13a. Here, silicone 13a has to be placed in a state where siloxane is allowed to vaporize to the outside of container 100. For example, if a lid of container 100 is kept open, the siloxane vaporizing from silicone 13a adheres to the surface of antireflection film 12.

Silicone 13a is a material based on an organo polysilicon in which organic groups are attached to siloxane (with siloxane linkage), and is high in oil resistance, oxidation resistance, and heat resistance, and also has insulating properties. Examples of silicone 13a include silicone resins used as adhesive agents (adhesive resins); silicone coating agents used as water-repellents; silicone oils; and the like. Since such silicone 13a contains low molecular siloxanes, low molecular siloxane gas is generated from silicone 13a.

In addition, in the siloxane coat process in which siloxane layer 13 is formed, silicone 13a in container 100 may be heated. Alternatively, the siloxane coat process may be conducted under a heating atmosphere. This makes it possible to promote the vaporization of the siloxane from silicone 13a, and hence increase the amount of the siloxane gas generated per unit time. Accordingly, siloxane layer 13 can be formed in a short period.

Moreover, the siloxane coat process may be conducted in a closed space. For example, substrate 11 on the surface of which antireflection film 12 is formed and container 100 containing silicone 13a in a state where siloxane is allowed to vaporize to the outside of container 100 may be arranged in a space (room) surrounded by walls from all sides. By placing substrate 11 and silicone 13a in a closed space together as described above, siloxane layer 13 can be easily formed even with siloxane spontaneously vaporizing from silicone 13a.

Note that when siloxane layer 13 is formed in a closed space at room temperature by using the siloxane spontaneously vaporizing from silicone 13a, siloxane layer 13 can be formed in several hours to several days. In this case, siloxane layer 13 can be formed in a shorter period by further heating silicone 13a to facilitate the vaporization of the siloxane. For example, when silicone 13a is heated to 100 °C or above, silicone layer 13 can be formed in 30 minutes or less.

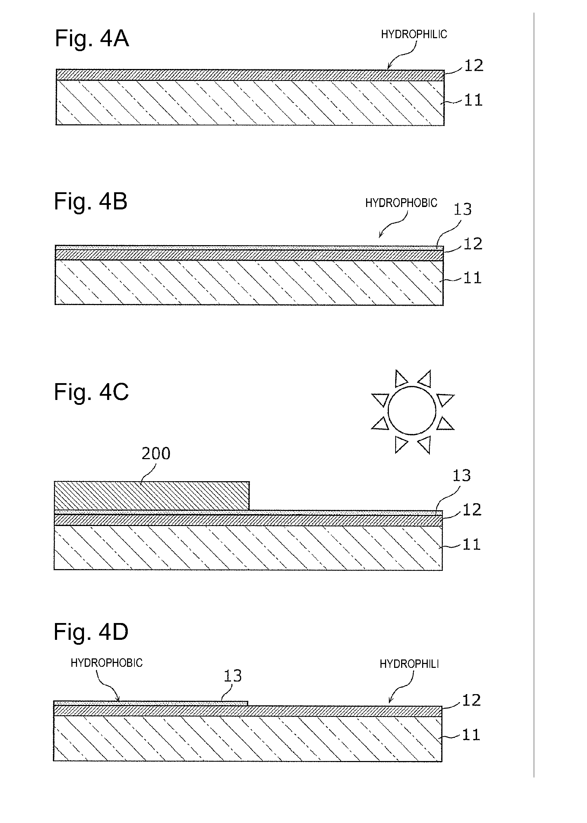

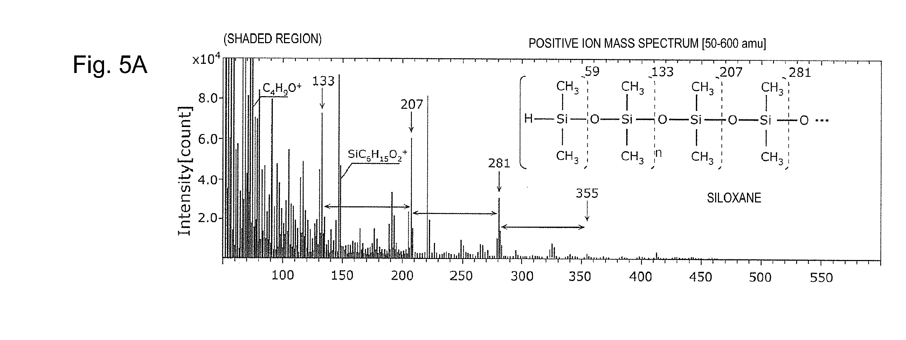

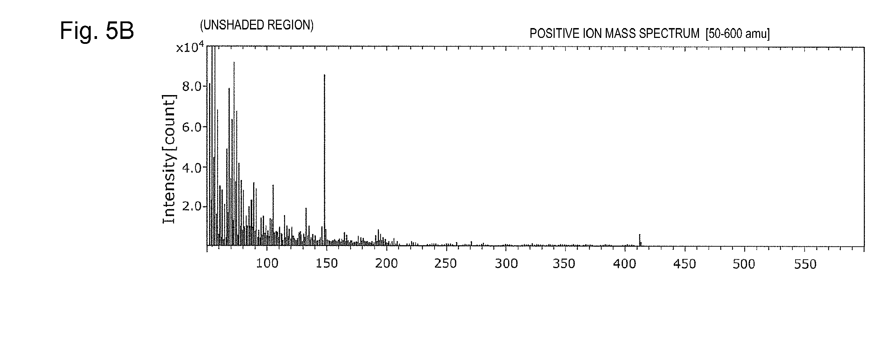

Here, an experiment conducted to check whether antireflection film 12 is coated with siloxane layer 13 and findings from this experiment are described by using Figs. 4A to 4D, and Figs. 5A and 5B. Figs. 4A to 4D are diagrams for describing processes in the experiment, and Figs. 5A and 5B are graphs illustrating the TOF-SIMS measurement results of a surface layer (exposed layer) in a region (shaded region) in which a light shield member is placed on a translucent or transparent substrate and in a region (unshaded region) in which no light shield member is placed on the translucent or transparent substrate.

In this experiment, first, as illustrated in Fig. 4A, substrate 11 on a surface of which antireflection film 12 is formed is prepared in the same manner as in Fig. 3. Here, the surface of antireflection film 12 is hydrophilic. Note that a glass substrate is used as substrate 11.

Subsequently, as illustrated in Fig. 4B, siloxane is attached to the surface of antireflection film 12 by the same method as in Figs. 3A and 3B. Thus, siloxane layer 13 is formed on the surface of antireflection film 12. Here, the surface of siloxane layer 13 is hydrophobic because of the nature of the siloxane.

Subsequently, as illustrated in Fig. 4C, light shieldmember 200 is arranged to partially cover siloxane layer 13, followed by exposure to the outside. In other words, the substrate is disposed in a sunlit place. For example, a black shield plate is used as light shield member 200.

Subsequently, as illustrated in Fig. 4D, light shieldmember 200 is detached. Fig. 5A illustrates the TOF-SIMS measurement result of the surface layer in the region where light shield member 200 is placed. Meanwhile, Fig. 5B illustrates the TOF-SIMS measurement result of the surface layer in the region where light shield member 200 is not placed.

As illustrated in the mass spectrum of Fig. 5A, it can be seen that a peak appears every increase in atomic mass by 74 for the surface layer in the region (shaded region) where light shield member 200 is placed. This increment (74) in atomic mass is equal to the atomic mass (74) of a siloxane unit ((CH₃)₂SiO) in siloxane. As described above, it can be found that peaks attributable to the siloxane appear in the case of the surface layer in the region where light shield member 200 is placed, and it can be seen that this surface layer is siloxane layer 13.

On the other hand, as illustrated in the mass spectrum of Fig. 5B, it can be seen that the peaks attributable to siloxane do not appear in the case of the surface layer in the region (unshaded region) where light shield member 200 is not placed. In other words, it is conceivable that siloxane layer 13 is removed by the exposure to the outside. This is presumably because siloxane layer 13 receives ultraviolet rays (UV) upon the exposure to the outside, and the siloxane attached to antireflection film 12 is detached from antireflection film 12.

From these experimental results, it is found that siloxane layer 13 remains present in the region where light shield member 200 is placed, whereas siloxane layer 13 is removed in the region where light shield member 200 is not placed. In other words, siloxane layer 13 is present and the exposed surface remains hydrophobic in the region where light shieldmember 200 is placed, whereas siloxane layer 13 is removed to expose antireflection film 12, and the exposed surface becomes hydrophilic again in the region where light shield member 200 is not placed.

In addition, it is also found that siloxane layer 13 covering antireflection film 12 can be removed by irradiation with ultraviolet rays.

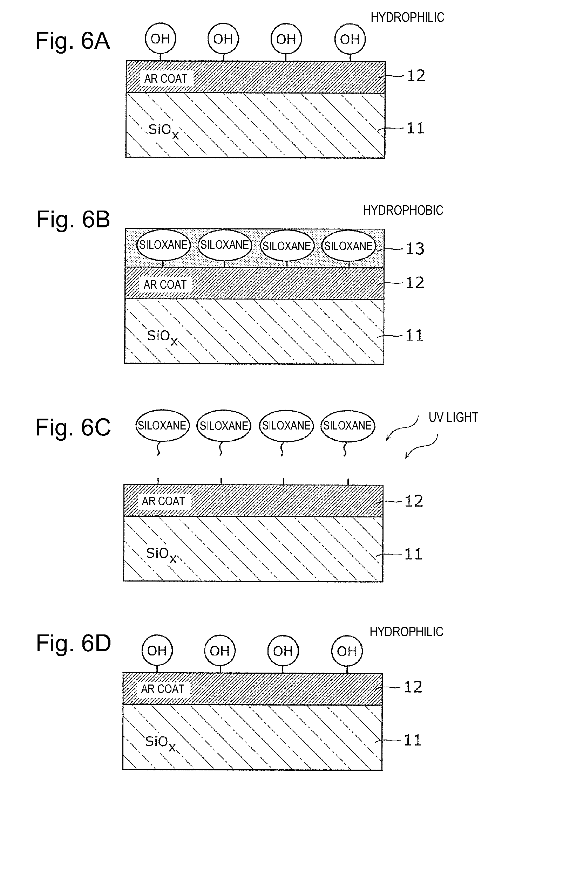

Figs. 6A to 6D are diagrams schematically illustrating a surface reaction in the region where light shield member 200 is placed in Figs. 4A to 4D.

As illustrated in Fig. 6A, antireflection film 12 is exposed in Fig. 4A, and the OH groups make the exposed surface hydrophilic.

As illustrated in Fig. 6B, since the siloxane adheres to the surface of antireflection film 12, and siloxane layer 13 is formed to cover antireflection film 12 in Fig. 4B, the exposed surface is hydrophobic.

As illustrated in Fig. 6C, because of the exposure to the outside, ultraviolet rays contained in sunlight causes detachment of the siloxane attached to antireflection film 12 in Fig. 4C. Thus, siloxane layer 13 is removed.

As illustrated in Fig. 6D, siloxane layer 13 is removed to expose antireflection film 12 in Fig. 4D, so that the exposed surface becomes hydrophilic again.

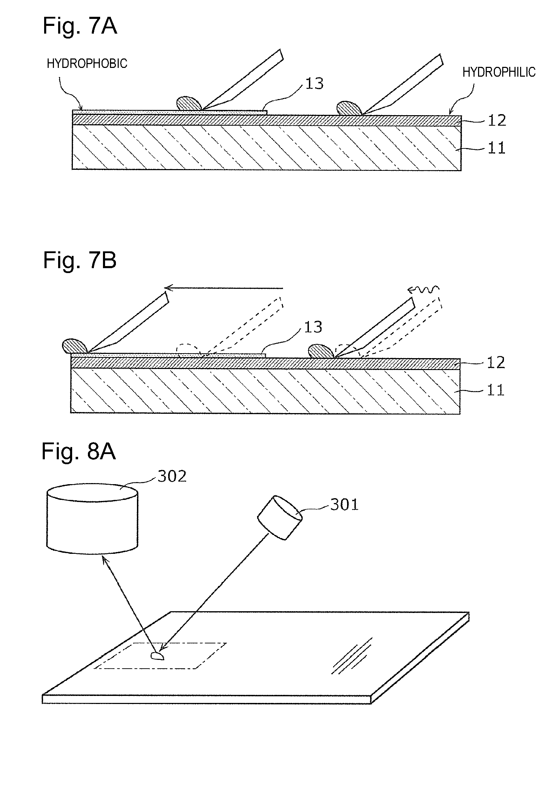

Next, operations and effects of transparent substrate 10 according to this embodiment are described by using Figs. 7A and 7B. Figs. 7A and 7B are diagrams for describing operations and effects of the translucent or transparent substrate according to this embodiment, and correspond to the translucent or transparent substrate in Fig. 4D.

As illustrated in Fig. 7A, Dirt is attached to each of a portion where siloxane layer 13 is exposed and a portion where antireflection film 12 is exposed, and the dirt is removed by wiping with a razor or the like. In this case, as illustrated in Fig. 7B, the dirt attached to siloxane layer 13 can be removed easily. On the other hand, the dirt attached to antireflection film 12 is difficult to remove.

This is because when dirt is once attached to antireflection film 12, the dirt cannot be removed easily because of the hydrophilic surface or the rugged structure, whereas the siloxane blocks dirt when siloxane layer 13 is provided, and hence the attached dirt can be removed easily. Note that, after the removal of the dirt, it is preferable to wash the surface of siloxane layer 13 with an alcohol or the like.

When siloxane layer 13 is formed as the surface layer as described above, an attached dirt can be removed easily. Especially, in the case of conventional translucent or transparent substrates, some types of dirt (curable adhesive resins and the like) attached to antireflection film 12 are difficult to remove by cleaning. In this respect, when siloxane layer 13 is formed, dirt, which has been difficult to remove conventionally, can be removed easily.

In addition, such types of dirt difficult to remove have required a special cleaning solvent or a special cleaning method so far. In this respect, transparent substrate 10 of this embodiment makes it possible to remove such types of dirt easily, and hence eliminates the need for a special cleaning solvent or a special cleaning method.

Moreover, when siloxane layer 13 is formed as the surface layer, a mark of dirt is less likely to be left after removal of the dirt. Specifically, suppose a case where siloxane layer 13 is not formed (the exposed surface is the antireflection film) . In such a case, even when dirt can be removed, the antireflection film is stained with the dirt, and a mark of the dirt is conspicuous. In contrast, when siloxane layer 13 is formed as in the case of this embodiment, the dirt is blocked by the siloxane, and transparent substrate 10 is less likely to be stained with the dirt. Accordingly, almost no mark of the dirt is left after removal of the dirt.

In addition, in general, a translucent or transparent substrate with a lower reflectance (with a higher transmittance) is more preferable. However, the higher the transmittance is, the more conspicuous the dirt is. Hence, the transmittance cannot be increased very much from the viewpoint of the appearance. On the other hand, since dirt attached to the surface of transparent substrate 10 in this embodiment can be removed easily, the transmittance of the translucent or transparent substrate can be designed without taking the attachment of dirt into consideration. Accordingly, the light-transmitting performance (reflection performance) of the translucent or transparent substrate can be improved easily.

In addition, in transparent substrate 10 of this embodiment, siloxane layer 13 can be easily removed by irradiation with ultraviolet rays to expose antireflection film 12. For this reason, siloxane layer 13 may be provided as the surface layer in the manufacturing process to facilitate the removal of dirt, and siloxane layer 13 may be removed before shipment, so that antireflection film 12 can be exposed as the surface layer in the product. Note that since the surface of antireflection film 12 in this embodiment is hydrophilic, it is possible to reduce attachment of dirt to the surface of transparent substrate 10 by exposing antireflection film 12 on the surface again. Siloxane layer 13 can be easily removed by irradiation with ultraviolet rays as described above. This enables selection between siloxane layer 13 and the antireflection film 12 as the surface layer without any process load.

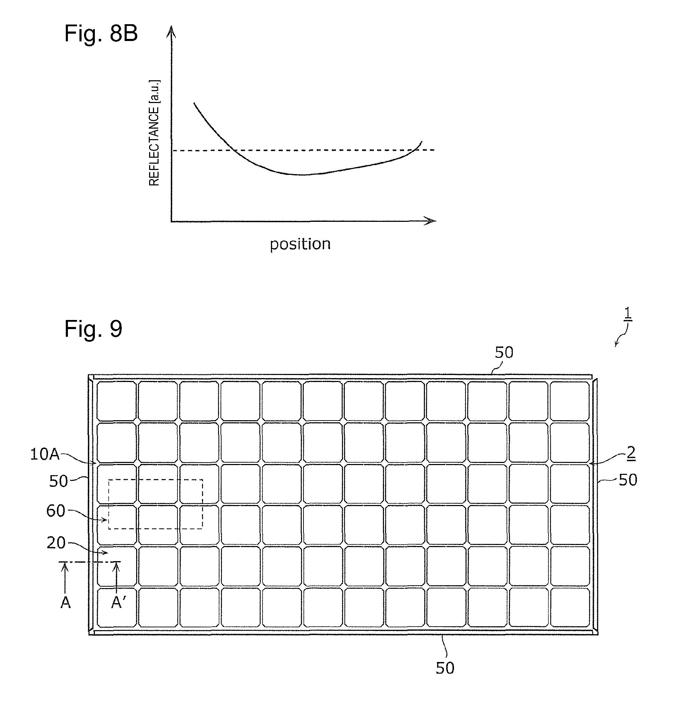

Note that, for evaluating dirt attached to transparent substrate 10, the inventors of this application have found the following evaluation method. This evaluation method is described by using Figs. 8A and 8B. Fig. 8A is a diagram for describing the method of evaluating dirt attached to the translucent or transparent substrate according to this embodiment. Fig. 8B is a graph illustrating an example of a reflectance distribution of a translucent or transparent substrate used for the evaluation.

Conventionally, evaluation of dirt attached to a translucent or transparent substrate such as a glass substrate and its appearance has been often based on sensory evaluation. For this reason, there are such a problem that the results are different among persons, places, situations, impressions, and the like, and such a problem that management using an actual limit sample (specimen) is necessary. In addition, it is difficult to accurately evaluate a substrate with a high light transmittance such as a glass substrate, even when a color difference meter or the like is used.

In this respect, the inventors of this application have conducted intensive study, and consequently found that dirt and the like of a translucent or transparent substrate can be evaluated quantitatively by measuring the reflectance of the translucent or transparent substrate.

Specifically, as illustrated in Fig. 8A, light source 301 and integrating sphere 302 are disposed above transparent substrate 10, and a predetermined region of transparent substrate 10 is irradiated with light from light source 301. Then, light (measurement light) reflected from transparent substrate 10 is allowed to be incident to integrating sphere 302, and the reflectance is measured. The reflectance can be measured by using, for example, a spectrophotometer (SolidSpec-3700) manufactured by Shimadzu Corporation.

As light source 301, for example, both a deuterium lamp and a halogen lamp are used, so that the wavelength region of the emitted light can be at least from 400 nm to 800 nm. Note that a light source which emits monochromatic light with a peak wavelength of, for example, 550 nm may be used as light source 301.

Integrating sphere 302 calculates the reflectance on the basis of the light reflected from transparent substrate 10. Fig. 8B illustrates an example of a reflectance distribution on a predetermined region of transparent substrate 10.

Here, when the reflectance exceeds a certain threshold, it can be determined that some dirt is present on transparent substrate 10. It is also possible to determine that some dirt is present on the transparent substrate 10 being evaluated, if the difference between the reflectance of transparent substrate 10 being evaluated and the reflectance of a standard translucent or transparent substrate (reference) is a certain value or greater. In any case, the degree of dirtiness can be accurately managed by the quantitative evaluation using a numeric value, namely, reflectance.

Note that, from experiments conducted by the inventors of this application, it is found that, for example, when the reflectance is about 1.2 times that of the reference, the dirt is not conspicuous, whereas when the reflectance is 1.5 times that of the reference, the dirt is conspicuous.

The above-described evaluation method makes it possible to obtain a constant result irrespective of the person, the place, the situation, and the impression, and hence dirt of a translucent or transparent substrate can be evaluated quantitatively. This makes it possible to numerically manage the limit of the appearance of a translucent or transparent substrate. In addition, this eliminates the need for an actual limit sample (specimen) and for management using an actual substrate. In addition, since the quantitative evaluation provides an objective evaluation, information can be provided more accurately to a third person.

Note that this evaluation method is applicable when the exposed surface is any one of siloxane layer 13, antireflection film 12, and substrate 11.

### [Solar Cell Module]

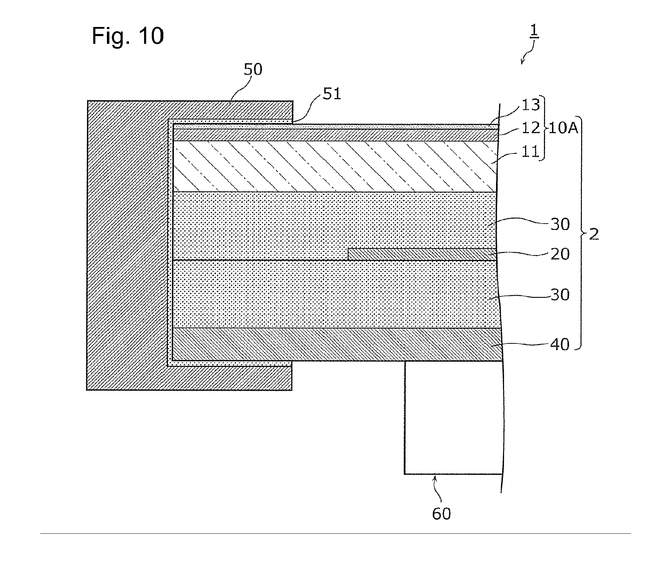

Next, a configuration of solar cell module 1 according to an embodiment of the invention is described by using Fig. 9 and Fig. 10. Fig. 9 is a plan view of a solar cell module according to the embodiment of the invention. Fig. 10 is an enlarged cross-sectional view of part of the solar cell module taken along the line A-A' of Fig. 9.

As illustrated in Figs. 9 and 10, solar cell module 1 includes translucent or transparent substrate 10A (hereinafter referred to as transparent substrate 10A), solar cells 20, filler material 30, back cover 40, frames 50, and terminal box 60.

As illustrated in Fig. 9, solar cells (solar cell elements) 20 are arranged in a matrix. Solar cells (solar cell elements) 20 are photoelectric conversion elements (photovoltaic elements) which convert light such as sunlight into electric power.

Solar cells 20 arranged in the row direction form cell strings (solar cell strings), and each pair of adjacent solar cells 20 are electrically connected to each other with a conductive tab wire (interconnector). Solar cells 20 in each cell string are connected in series. Note that the cell strings arranged in the column direction are electrically connected to each other by crossover wiring or the like. The cell strings are connected in series or in parallel to form a cell array.

As illustrated in Fig. 10, solar cell module 1 has a structure in which solar cells 20 are sealed in filler material 30 between transparent substrate 10A and back cover 40 facing each other. In addition, a stack including transparent substrate 10A, solar cells 20 in a cell array, filler material 30, and back cover 40 is solar cell panel 2. As illustrated in Fig. 9, solar cell panel 2 has, for example, a rectangular shape. Solar cell panel 2 is, for example, a panel having a rectangular shape with a length of approximately 1600 mm and a width of approximately 800 mm.

Transparent substrate 10A is a surface protective member (front cover) which protects the inside of solar cell module 1 from outer environments such as weather, impact from the outside, and fire, and secures the long-term reliability of solar cell module 1 against exposure to the outside. For example, transparent substrate 10A protects light-receiving surfaces of solar cells 20, and is arranged on the light-receiving surface side of solar cells 20.

In this embodiment, transparent substrate 10 illustrated in Fig. 1 is used as transparent substrate 10A. Accordingly, transparent substrate 10A includes substrate 11, antireflection film 12, and siloxane layer 13, as illustrated in Fig. 10. In this embodiment, substrate 11 is a glass substrate. Transparent substrate 10A is provided on the light-receiving side of solar cell module 1, and receives light such as sunlight. Specifically, siloxane layer 13 receives sunlight. In other words, the surface of siloxane layer 13 serves as the exposed surface of solar cell module 1.

Filler material 30 is a resin material such as ethylene-vinyl acetate (EVA), and seals solar cells 20. For example, solar cells 20 are placed between two EVA sheets (resin sheets), followed by a laminate process. Thus, solar cell panel 2 in which solar cells 20 are sealed in filler material 30 made of EVA can be fabricated.

Back cover 40 is a back surface protective member which protects a back surface of solar cell module 1 from the outer environment. Back cover 40 is, for example, made of a resin or glass. Note that when light is captured also on the back surface side of solar cell module 1 to generate electric power, a translucent or transparent substrate such as a glass substrate or a transparent resin substrate is used as back cover 40. In this case, transparent substrate 10 illustrated in Fig. 1 may be used as back cover 40 and arranged, so that siloxane layer 13 can be on the light-receiving surface side (exposed surface side).

Frames 50 are outer frames covering peripheral endportions of solar cell panel 2. In this embodiment, frames 50 are aluminum frames made of aluminum. As illustrated in Fig. 9, four frames 50 are used, and mounted on end portions on four sides of solar cell panel 2. In addition, as illustrated in Fig. 10, frames 50 are fixed to the end portions of the sides of solar cell panel 2 with, for example, adhesive agent 51 made of a silicone resin. Note that a sealant material made of rubber maybe inserted between frame 50 and solar cell panel 2 for water-proofing and dust-proofing.

Terminal box 60 is provided to extract electric power generated by the cell array in solar cell panel 2. In this embodiment, terminal box 60 is fixed to back cover 40. Terminal box 60 accommodates multiple circuit components actually mounted on a circuit board. In addition, an insulating adhesive agent such as a silicone resin is potted in terminal box 60.

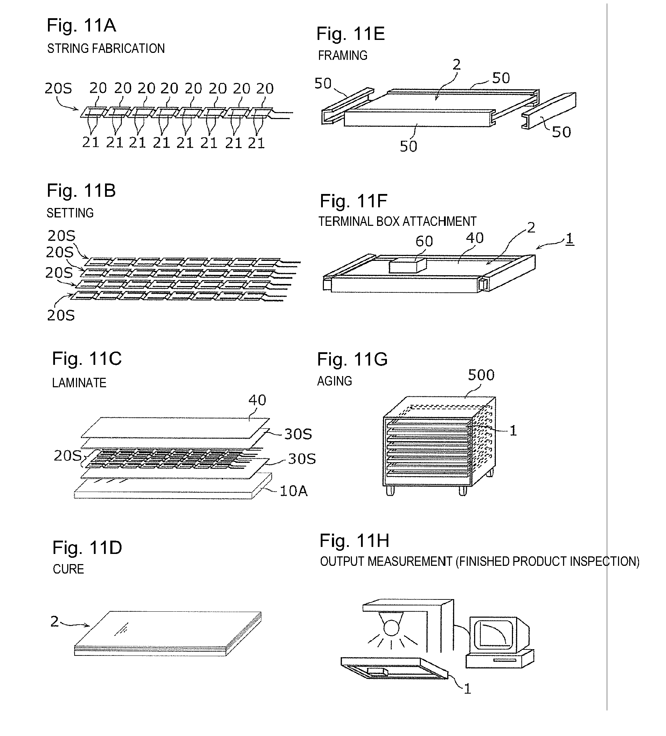

Next, a method of manufacturing solar cell module 1 according to this embodiment is described by using Figs. 11A to 11H. Figs. 11A to 11H are diagrams for describing the method of manufacturing a solar cell module according to this embodiment.

As illustrated in Fig. 11A, a string is fabricated by connecting solar cells 20 to each other (cell string fabrication process). Specifically, electrodes of adjacent solar cells 20 are sequentially connected to each other through two tab wires 21 with solder or the like to fabricate each cell string 20S in which solar cells 20 are connected in a line.

Next, cell string 20S are set as illustrated in Fig. 11B (setting process). Specifically, cell strings 20S are arranged, so that solar cells 20 can be arranged two-dimensionally.

Next, as illustrated in Fig. 11C, solar cell panel 2 is fabricated by thermocompression bonding a stack of transparent substrate 10A, solar cells 20, and resin sheets 30S (laminate process). Specifically, the set cell strings 20S are placed between two resin sheets 30S which are EVA sheets, and transparent substrate 10A and back cover 40 are arranged above and below them to prepare the stack. Then, this stack is thermocompression bonded (heated and compression bonded), for example, at a temperature of 100°C or above in a vacuum. By the thermocompressionbonding, resin sheets 30S are heated and melted to form filler material 30 which seals solar cells 20. Thus, solar cell panel 2 can be fabricated.

In this embodiment, transparent substrate 10 manufactured by the method illustrated in Fig. 3 is used as transparent substrate 10A. In other words, a transparent substrate in which siloxane layer 13 is formed on substrate 11 in advance is used as transparent substrate 10A.

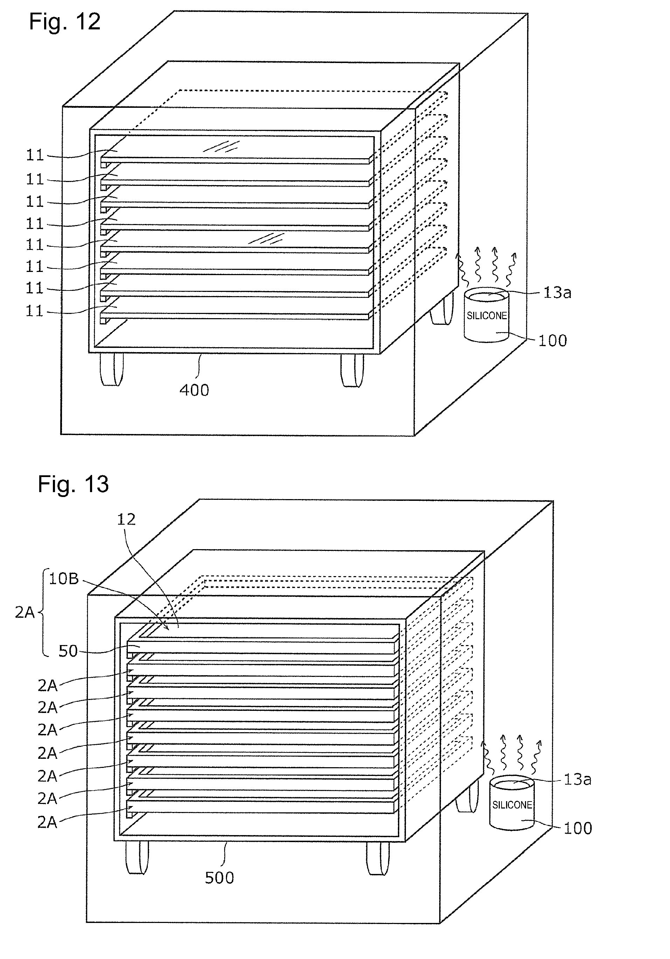

In this case, for example, as illustrated in Fig. 12, substrate rack 400 on which substrates 11 are mounted, while being away from each other is placed in a room which provides a closed space, and container 100 containing silicone 13a is also placed in this room. Antireflection film 12 (unillustrated in Fig. 12) is formed on each substrate 11. Consequently, siloxane (siloxane gas) spontaneously vaporizing from silicone 13a adheres to the surface of antireflection film 12 to form siloxane layer 13. In this manner, the siloxane coat process of forming siloxane layer 13 is conducted before the setting process or the laminate process in this embodiment. For example, the formation of siloxane layer 13 on substrate 11 maybe conducted when substrate 11 is stored on a pallet.

Next, as illustrated in Fig. 11D, a heat treatment is conducted on solar cell panel 2 at around 150°C in order to cause cross-linking which increases the strength of molecular bonds of the resin in filler material 30 (a cure process). It is preferable to conduct this cure process, when EVA is used as the material of filler material 30 (resin sheets 30S), but this process does not necessarily has to be conducted.

Next, as illustrated in Fig. 11E, frames 50 are attached to solar cell panel 2 (framing process). Specifically, frames 50 are fixed to peripheral end portions of four sides of solar cell panel 2 with adhesive agent 51 (unillustrated in Fig. 11) such as a silicone resin.

Next, as illustrated in Fig. 11F, terminal box 60 is attached to back cover 40. Here, a silicone resin is potted in terminal box 60. In this manner, solar cell module 1 is obtained.

Next, as illustrated in Fig. 11G, solar cell modules 1 are aged, until the silicone resin (adhesive resin) such as adhesive agent 51 has set (aging process). Specifically, solar cell modules 1 are mounted on panel rack 500, and allowed to stand until the silicone resin used in solar cell modules 1 has completely set, and until the temperature of solar cell panels 2 drops to about room temperature (around 25°C).

Next, as illustrated in Fig. 11H, output measurement (finished product inspection) of solar cell module 1 is conducted, and then solar cell module 1 is packed.

Note that, in this embodiment, the siloxane coat process of forming siloxane layer 13 on substrate 11 is conducted separately in the process of fabricating transparent substrate 10A before the laminate process as described above, but the siloxane coat process is not limited thereto.

For example, by using translucent or transparent substrate 10B (hereinafter referred to as transparent substrate 10B) in which antireflection film 12 is formed on substrate 11 (the same as transparent substrate 10A, except that siloxane layer 13 is not formed), siloxane layer 13 may be formed on antireflection film 12 of transparent substrate 10B in the aging process.

Specifically, as illustrated in Fig. 13, a panel rack (aging rack) 500 on which solar cell panels 2A including transparent substrates 10B and frames 5 are mounted is placed in a room which provides a closed space, and container 100 containing silicone 13a is placed in this room. By placing solar cell panels 2A and silicone 13a in the closed space together, siloxane (siloxane gas) spontaneously vaporizing from silicone 13a adheres to the surface of antireflection film 12. In this manner, siloxane layer 13 can be formed on a surface (the surface of antireflection film 12) of each solar cell panel 2A. As described above, the siloxane coat process may be the aging process itself, and siloxane layer 13 may be formed in the aging process.

In addition, in this embodiment, container 100 containing silicone 13a is provided separately when siloxane layer 13 is formed. Alternatively, siloxane layer 13 may be formed by using a silicone used in manufacturing solar cell module 1. For example, siloxane layer 13 may be formed by using an adhesive resin made of a silicone resin used in manufacturing solar cell module 1. Specifically, siloxane layer 13 may be formed by using the silicone resin used for fixing the frames to solar cell panel 2 or the silicone resin potted in terminal box 60.

As described above, siloxane layer 13 may be formed by the siloxane spontaneously generated from the silicone used in manufacturing solar cell module 1. In this case, however, the silicone (silicone resin or the like) used has to be applied to solar cell module 1 in a state where the siloxane is allowed to vaporize from the silicone. In addition, the amount of the silicone used in solar cell module 1 is not very large, and the siloxane spontaneously generated from the silicone is also not very large in some cases. For these reasons, it is preferable to conduct a treatment for causing the siloxane to be actively generated from the silicone, in this case. For example, it is preferable to heat the silicone or the solar cell panel in order to increase the amount of the siloxane vaporizing from the silicone per unit time. In addition, it is preferable to conduct the siloxane coat process (aging process) in a closed space in order to efficiently attach the siloxane vaporizing from the silicone to the surface of antireflection film 12. This makes it possible to form siloxane layer 13 also by using the siloxane spontaneously generated from the silicone used in manufacturing solar cell module 1.

As described above, siloxane layer 13 is formed on transparent substrate 10A in solar cell module 1 in this embodiment. This makes it possible to easily remove dirt attached to transparent substrate 10A.

Especially, in the case of conventional translucent or transparent substrates, some types of dirt attached to antireflection film 12 are difficult to remove by cleaning. For example, when dirt of an adhesive agent or a filler material used in manufacturing or installing a solar cell module or other occasions, a fat component such as a finger mark of a user (a manufacturing operator, an installation operator, or a customer), or the like adheres to antireflection film 12, the dirt cannot be removed without using a special cleaning solvent or a special cleaning method. In contrast, siloxane layer 13 is formed on antireflection film 12 in this embodiment. Hence, even when such dirt, which would be otherwise difficult to remove, is attached, the dirt can be removed easily by wiping or the like, without using any special cleaning solvent or special cleaning method.

In addition, as in the case of transparent substrate 10 described above, since siloxane layer 13 is formed as the surface layer of transparent substrate 10A, transparent substrate 10 is less likely to be stained with attached dirt such as a fat component. Hence, almost no mark of the dirt is left after removal of the dirt.

Conventionally, a very high transmittance cannot be employed, because the attached dirt becomes more conspicuous with the increase in transmittance. In contrast, as in the case of transparent substrate 10 described above, dirt attached to the surface can be removed easily in this embodiment. Hence, the transmittance of the translucent or transparent substrate can be designed without taking the attachment of dirt into consideration. Hence, the light-transmitting performance (reflection performance) of a translucent or transparent substrate can be improved easily.

In addition, in solar cell module 1 in this embodiment, the surface of solar cell module 1 can be converted from a hydrophilic one (antireflection film 12) to a hydrophobic one (siloxane layer 14) by forming siloxane layer 13 on the surface of antireflection film 12.

When the surface of solar cell module 1 is converted to a hydrophobic one as described above, the decrease in light-capture efficiency can be suppressed. This point is described below.

For example, a hydrophilic surface easily allows attachment of water, and hence has poor water draining properties. Accordingly, when the exposed surface of a solar cell module is hydrophilic (antireflection film 12), water tends to be accumulated on the exposed surface, so that the light-capture efficiency of the solar cell module decreases.

In contrast, solar cell module 1 in this embodiment has improved water draining properties, because the exposed surface is hydrophobic. This makes it possible to suppress the decrease in light-capture efficiency of solar cell module 1 due to the attachment of water.

In addition, snow piling up on the exposed surface of solar cell module 1 remarkably lowers the light-capture efficiency. In this respect, when the exposed surface of solar cell module 1 is hydrophobic, snow is less likely to pile up on the exposed surface. For this reason, a great decrease in light-capture efficiency of solar cell module 1 due to snow covering can be suppressed.

As described above, when the exposed surface of solar cell module 1 is made hydrophobic by siloxane layer 13, the decrease in light-capture efficiency can be suppressed.

In addition, in solar cell module 1 in this embodiment, siloxane layer 13 of transparent substrate 10A is removed by irradiation with ultraviolet rays to expose antireflection film 12, as in the case of transparent substrate 10 described above. Accordingly, the exposed surface (light-receiving surface) of solar cell module 1 is hydrophobic siloxane layer 13 before the ultraviolet irradiation, whereas the exposed surface (light-receiving surface) of solar cell module 1 is hydrophilic antireflection film 12 after the ultraviolet irradiation.

Accordingly, after finished solar cell module 1 is installed at a predetermined outside site, solar cell module 1 is exposed to sunlight containing ultraviolet rays, and siloxane layer 13 is hence naturally removed from transparent substrate 10A. As a result, antireflection film 12 is exposed, and the exposed surface of solar cell module 1 returns from hydrophobic one to hydrophilic one.

When the exposed surface of solar cell module 1 becomes hydrophilic as described above, water is easily attached to the exposed surface, and soil dust and the like can be easily rinsed away. This makes it possible to reduce soil dust attached to the exposed surface of solar cell module 1.

Note that, in a case where the hydrophilic surface and the hydrophobic surface are selectively used or other cases, the natural removal of siloxane layer 13 does not necessarily have to be waited for, but siloxane layer 13 may be intentionally removed in manufacturing solar cell module 1 or after installation of solar cell module 1. For example, in a case where it is desirable to keep the surface hydrophobic (siloxane layer 13) in the manufacture and convert the surface to hydrophilic one (antireflection film 12) after the manufacture, siloxane layer 13 temporarily formed may be removed by ultraviolet irradiation (removal process) in manufacturing solar cell module 1.

Moreover, even if the siloxane is attached before the inspection process, the siloxane exerts almost no influence on the inspection, because the film thickness of the siloxane is at a level of several nanometers.

In addition, the attached siloxane exerts almost no influence on the transmittance, and hence does not exert any influence on the output, either.

### (Other modifications etc.)

The solar cell module according to the invention is described above on the basis of the above-described embodiments. However, the invention is not limited to the above-described embodiments.

For example, in the solar cell module 1 of the above-described embodiment, solar cells 20 are of the monofacial type in which only the surface on the transparent substrate 10A side (front surface side) serves as a light-receiving surface. However, solar cells 20 may be of the bifacial type in which both surfaces serve as light-receiving surfaces.

Moreover, in solar cell module 1 of the above-described embodiment, solar cells 20 are arranged in a matrix in a plan view, but solar cells 20 are not limited thereto. For example, solar cells 20 may be arranged in a circle, in a straight line, or a curved line (one-dimensionally).

Moreover, in the above-described embodiment, when the siloxane coat process is conducted in the closed space, substrate 11 and the silicone are placed in a room together. However, the closed space in this case is not limited to a room, unless convection occurs intensely in the space. The closed space may be provided by a cover, a fence, or the like.

Moreover, the surface of antireflection film 12 of each of transparent substrates 10 and 10A in the above-described embodiments is hydrophilic, but is not limited thereto.

Moreover, the invention also includes modes obtainable by subjecting the embodiments to various modifications conceivable by those skilled in the art, and modes achievable by combining any ones of constituents and functions of the embodiments within a range not departing from the gist of the invention.

## Claims

1. A method of manufacturing a solar cell module comprising:
a step of obtaining a solar cell module that includes a translucent or transparent substrate including a substrate provided with translucency or transparency, and an antireflection film formed on a surface of the substrate provided with translucency or transparency; and
a siloxane coat step of forming a siloxane layer on a surface of the antireflection film.

2. The method of manufacturing a solar cell module according to claim 1, wherein
the siloxane layer is formed on substantially the entire surface of the antireflection film in the siloxane coat step.

3. The method of manufacturing a solar cell module according to claim 1 or 2, further comprising
a laminate step of thermocompression bonding a stack of the translucent or transparent substrate, a solar cell, and a resin sheet, wherein
the siloxane coat step is conducted before the laminate step.

4. The method of manufacturing a solar cell module according to claim 1 or 2, further comprising:
a laminate step of thermocompression bonding a stack of the translucent or transparent substrate, a solar cell, and a resin sheet, and
a frame fixation step of fixing a frame to a circumference of the laminated stack by using an adhesive resin, wherein
the siloxane coat step is conducted after the frame fixation step.

5. The method of manufacturing a solar cell module according to claim 4, wherein the siloxane coat step comprises
a aging step of aging the adhesive resin until the adhesive resin has set.

6. The method of manufacturing a solar cell module according to claim 4 or 5, wherein
the adhesive resin is a silicone resin, and
the siloxane layer is formed of siloxane vaporizing from the silicone resin.

7. The method of manufacturing a solar cell module according to any one of claims 1 to 5, wherein
in the siloxane coat step, a silicone is placed in a state where siloxane is allowed to vaporize, and
the siloxane layer is formed of the siloxane vaporizing from the silicone.

8. The method of manufacturing a solar cell module according to claim 7, wherein
the silicone resin is heated in the siloxane coat step.

9. The method of manufacturing a solar cell module according to any one of claims 1 to 7, wherein
the siloxane coat step is conducted in a heating atmosphere.

10. The method of manufacturing a solar cell module according to any one of claims 1 to 9, wherein
the siloxane coat step is conducted in a closed space.

11. The method of manufacturing a solar cell module according to any one of claims 1 to 10, further comprising:
a removal step of removing the siloxane layer by irradiation with ultraviolet rays.

12. A method of manufacturing a solar cell module, comprising
obtaining a solar cell module that includes translucent or transparent substrate including a substrate provided with translucency or transparency and an antireflection film formed on a surface of the substrate, the method comprising:
forming a siloxane layer on a surface of the antireflection film.

13. A solar cell module, comprising:
a translucent or transparent substrate on a light-receiving side, wherein
the translucent or transparent substrate includes
a substrate provided with translucency or transparency,
an antireflection film formed on a surface of the substrate provided with translucency or transparency, and
a siloxane layer formed on a surface of the antireflection film.

14. A translucent or transparent substrate on a light-receiving side of a solar cell module, comprising:
a substrate provided with translucency or transparency;
an antireflection film formed on a surface of the substrate provided with translucency or transparency; and
a siloxane layer formed on a surface of the antireflection film.
